(19) **Europäisches Patentamt**
**European Patent Office**
**Office européen des brevets**

(11) **EP 3 719 507 B1**

(12) **EUROPEAN PATENT SPECIFICATION**

(45) Date of publication and mention
of the grant of the patent:
**27.11.2024 Bulletin 2024/48**

(21) Application number: **19167095.9**

(22) Date of filing: **03.04.2019**

(51) International Patent Classification (IPC):
**G01R 15/16** *(2006.01)*       **G01R 19/32** *(2006.01)*
**G01R 19/25** *(2006.01)*

(52) Cooperative Patent Classification (CPC):
**G01R 15/16; G01R 19/32;** G01R 19/2513

(54) **A VOLTAGE DETECTION DEVICE FOR MEDIUM VOLTAGE ELECTRIC INSTALLATIONS**

SPANNUNGSERFASSUNGSVORRICHTUNG FÜR ELEKTRISCHE MITTELSPANNUNGSANLAGEN

DISPOSITIF DE DÉTECTION DE TENSION POUR INSTALLATIONS ÉLECTRIQUES MOYENNE TENSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.10.2020 Bulletin 2020/41**

(73) Proprietor: **ABB Schweiz AG**
**5400 Baden (CH)**

(72) Inventors:
• **USAI, Roberto**
  **24048 Treviolo (BG) (IT)**
• **RIVA, Marco**
  **24040 Canonica d'Adda (BG) (IT)**

(74) Representative: **De Bortoli, Eros et al**
**Zanoli & Giavarini S.p.A.**
**Via Melchiorre Gioia, 64**
**20125 Milano (IT)**

(56) References cited:
**CN-A- 102 608 378    CN-A- 107 340 424**
**DE-A1- 3 640 242    US-A1- 2011 089 931**

• **LEVIGION M: "Temperatur-Kompensation elektrischer Groessen", TECHNISCHES MESSEN ATM, R.OLDENBOURG VERLAG. MUNCHEN, DE, vol. z119-8, no. 452, 1 September 1973 (1973-09-01), pages 177 - 180, XP002163913**

## Description

The present invention relates to the field of medium voltage electric installations, such as medium voltage power grid sections, switchboards, circuit breakers, contactors, disconnectors, and the like.

For the purposes of the present application, the term "medium voltage" (MV) is referred to apparatuses operating at voltages higher than 1 kV AC up to some tens of kV, e.g. up to 72 kV AC.

More particularly, the present invention relates to a detection device suitable for voltage metering purposes in MV electric installations.

As is known, MV electric installations are generally equipped with a number of detection devices to monitor suitable electric quantities (e.g. voltages or currents) and provide detection signals indicative of said electric quantities to suitable electronic devices, e.g. local or remote control units, protection relays or other computerized devices.

Voltage transformers are notoriously the most traditional detection devices employed for voltage metering purposes in MV electric installations.

Unfortunately, these detection devices generally have huge weight and size and are relatively expensive to manufacture at industrial level.

Further, they normally have a limited measurement range as the ferromagnetic core may be easily subject to saturation phenomena.

Resistive shunts are also widely used even if these voltage detection devices are generally quite cumbersome to install on the field and typically show high industrial costs.

A further class of voltage measuring devices include detection devices of the capacitive type, which are also known as Capacitive Voltage Dividers (CVDs).

These devices normally provide relevant advantages in terms of size and cost reduction with respect to other types of voltage detection devices.

However, they often show relevant limitations in terms of accuracy, as capacitive voltage measurements are strongly influenced by environmental factors, in particular by temperature.

CN102608378A discloses a detection device for medium voltage electric installations comprising a voltage sensing unit including a capacitive voltage divider sensing arrangement, said voltage sensing unit being operatively coupleable with a line conductor of an electric line and being adapted to provide first detection signals. The detection device further comprises an electronic arrangement operatively coupled with said voltage sensing unit wherein said electronic arrangement comprises a first amplification stage comprising a first tuning circuit adapted to tune said first amplification stage in response to environmental temperature variations. The electronic arrangement further comprise a second amplification stage comprising a second tuning circuit being adapted to tune a second amplification gain of said second amplification stage.

The journal article "Temperatur-Kompensation elektrischer Grössen" (TECHNISCHES MESSEN ATM. 1973-09-01 R.OLDENBOURG VERLAG., MUNCHEN) discloses the use of a NTC type thermistor in an operational amplifier feedback circuit for general temperature compensation via temperature dependent gain adjustment.

DE3640242A1 discloses a temperature compensating arrangement of a sensor comprising a first amplification stage with a first tuning circuit comprising a thermistor, said first tuning circuit being adapted to tune a first amplification gain of said first amplification stage in response to environmental temperature variations, the temperature compensating arrangement further comprising a second amplification stage coupled in cascade with the first amplification stage and comprising a tuning circuit for tuning a second amplification gain of said second amplification stage (and thus the overall amplification gain) via laser trimmed resistors.

CN107340424A discloses temperature compensation of a Hall-effect sensor with an amplification stage that comprises a NTC-resistor in the feedback network of an operational amplifier.

The main aim of the present invention is to provide a voltage detection device of the capacitive type for MV electric installations, which allows overcoming the above-mentioned issues.

More particularly, it is an object of the present invention to provide a voltage detection device of the capacitive type, which provides improved performances in terms of measurement accuracy.

Another object of the present invention is to provide a voltage detection device of the capacitive type, which shows a relatively small sensitivity to temperature variations over a wide range of operating temperatures.

Another object of the present invention is to provide a voltage detection device of the capacitive type, which is relatively easy and cheap to realize at industrial level.

In order to achieve these aim and objects, the present invention provides a voltage detection device for MV electric installations, according to the following claim 1 and related dependent claims.

In a general definition, the voltage detection device, according to the invention, comprises a voltage-sensing unit, which includes a capacitive voltage divider sensing arrangement.

Conveniently, said voltage-sensing unit is operatively coupleable with a line conductor of an electric line and it is adapted to provide first detection signals indicative of voltage levels of said line conductor.

The voltage detection device, according to the invention, further comprises an electronic arrangement operatively coupled with said voltage sensing unit.

Said electronic arrangement comprises a first amplification stage adapted to receive and process said first detection signals and to provide second detection signals indicative of voltage levels of said line conductor.

Said second detection signals are obtained by amplifying said first detection signals with a first amplification gain provided by said first amplification stage.

According to the invention, said first amplification stage comprises a first tuning circuit adapted to tune the first amplification gain provided by said first amplification stage in response to environmental temperature variations.

In this way, said first amplification stage can provide a first amplification gain variable as a function of temperature.

Thus, said first amplification stage can amplify said first detection signals and, at the same time, compensate, at least partially, temperature drift errors affecting said first detection signals due to temperature variations of said voltage sensing unit.

Said first tuning circuit comprises one or more thermistors of the NTC type. Preferably, said first amplification stage comprises an operational amplifier and a first polarization network operatively coupled with said first operational amplifier to set said first amplification gain. Conveniently, said first polarization network includes said first tuning circuit.

According to an aspect of the invention, said amplification arrangement comprises at least said first amplification stage arranged in proximity of said voltage sensing unit. In this way, said first tuning circuit can tune the first amplification gain provided by said first amplification stage in response to environmental temperature variations in proximity of said voltage sensing unit, which substantially follow temperature variations of said voltage sensing unit.

According to the invention, said amplification arrangement comprises a second amplification stage operatively coupled in cascade with said first amplification stage and adapted to receive and process said second detection signals and to provide third detection signals indicative of voltage levels of said line conductor.

Said third detection signals are obtained by amplifying said second detection signals with a second amplification gain provided by said second amplification stage.

Said second amplification stage comprises a second tuning circuit operativel) coupled with a tuning terminal of said electronic arrangement and adapted to tune the second amplification gain provided by said second amplification stage in response to manual interventions of an operator on said tuning terminal.

In this way, said second amplification stage can provide a second amplification gain that can be manually tuned by an operator by intervening on the tuning terminal of said second amplification stage.

Said second tuning circuit comprises one or more trimming resistors operatively coupled with said tuning terminal.

Preferably, said second amplification stage comprises a second operational amplifier and a third polarization network adapted to set the second amplification gain provided by said second operational amplifier. Conveniently, said third polarization network includes said second tuning circuit.

According to a further aspect, the present invention relates to a MV installation comprising the voltage detection device described above.

Further characteristics and advantages of the invention will emerge from the description of preferred, but not exclusive, embodiments, non-limiting examples of which are provided in the attached drawings, wherein:

- Figure 1 shows a schematic view of a switching apparatus including a plurality of detection devices, according to the invention;
- Figures 2A, 2B show schematic views of the detection device, according to the invention;
- Figures 3-5 schematically show the operation of the detection device, according to the invention.

Referring to the cited figures, the present invention relates to a detection device 1 for medium voltage electric installations.

In general, the detection device 1 is intended to be operatively installed on power grid sections, switchboards, circuit breakers, contactors, disconnectors and the like for voltage monitoring purposes.

The detection device 1 comprises a voltage sensing unit 10 operatively coupleable with a line conductor 101 of an electric line 100 and it is adapted to provide first detection signals DS1 indicative of voltage levels of said line conductor.

According to the invention, the detection device 1 is of the capacitive type. Thus, the voltage-sensing unit 10 comprises a capacitive voltage divider (CVD) sensing arrangement.

In general, the voltage-sensing unit 2 may be realized according to a variety of solutions of known type.

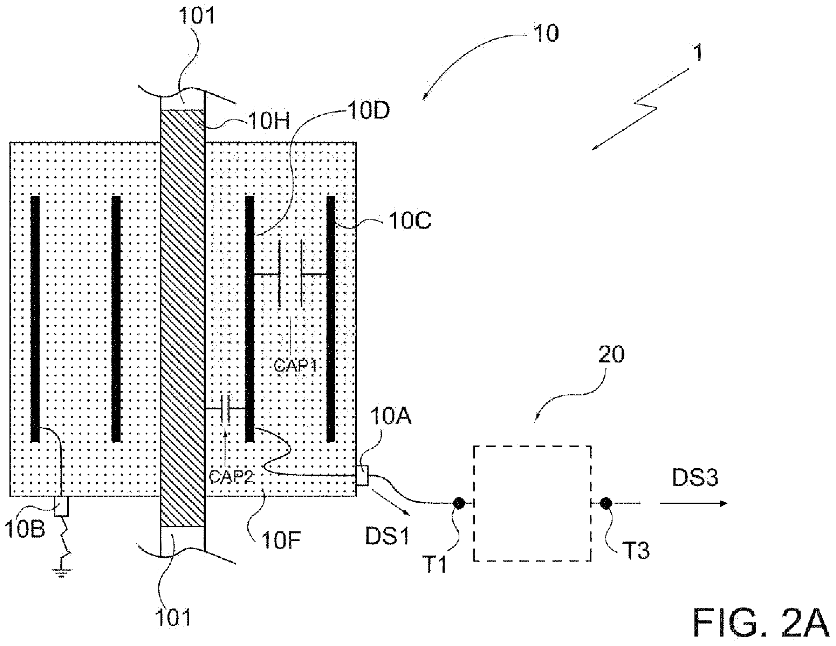

In figure 2A, a preferred embodiment for the voltage-sensing unit 10 is however shown.

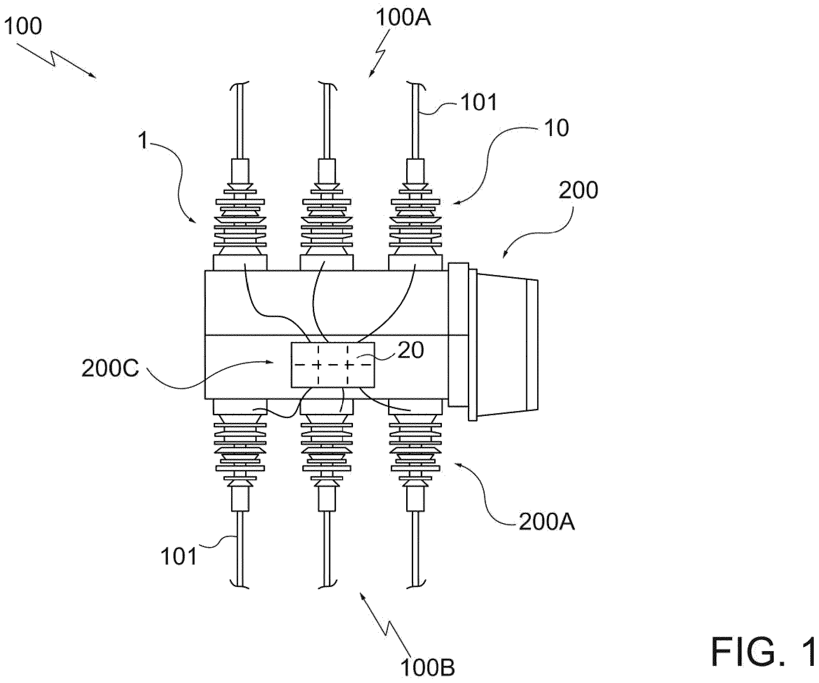

According to such an embodiment, the voltage-sensing unit 10 comprises an insulating body 10F made of dielectric material (e.g. a PTFE resin) that surrounds a conductive rod 10H. This latter is electrically connectable in a known manner with the line conductor 101 of an electric line 100 (see also figure 1).

The voltage-sensing unit 10 further comprises a first conductive shaped element 10D (e.g. a conductive ring) buried in the insulating body 10F.

Preferably, the first conductive element 10D is arranged coaxially with the conductive rod 10H in such a way to surround at least a portion of the conductive rod 10H.

The first conductive element 10D is electrically connected with an output terminal 10A of the voltage-sensing unit 10.

The voltage sensing unit 2 comprises a second conductive shaped element 10C (e.g. a conductive ring) buried in the insulating body 10F.

Conveniently, the second conductive element 10C is arranged coaxially with the conductive rod 10H and the first conductive element 10D in such a way to surround at least a portion of the first conductive element 10D.

The second conductive element 10C is electrically connected with a ground terminal 10B of the voltage-sensing unit, which, in operation, is electrically connected to ground.

As it is evident from figure 2A, the second conductive element 10C, the first conductive element 10D and the dielectric material included between said conductive elements form a first capacity CAP1, which generally has a relatively smaller value, e.g. in the range of tens of pF.

Similarly, the first conductive element 10D, the conductive rod 10H and the dielectric material included between said conductive elements form a second capacity CAP2, which generally has a larger value, e.g. in the range of hundreds of nF.

The two capacitances CAP1, CAP2 are electrically connected in series between the conductive rod 10H (i.e. the line conductor 101) and the ground. Thus, they form a capacitive voltage divider sensing arrangement having the terminal 10A as output terminal. In operation, at the output terminal 10A, the voltage-sensing unit 10 provides first detection signals DS1 indicative of the voltage of the line conductor 101.

According to the invention, the detection device 1 comprises an electronic arrangement 20 operatively coupled with the voltage sensing unit 10.

The electronic arrangement comprises an input terminal T1 and an output terminal T2.

The input terminal T1 is electrically connected with the output terminal 10A of the voltage-sensing unit 10 to as to receive the first detection signals DS1.

In operation, the output terminal T2 is electrically connected with a suitable local or remote electronic device (not shown), e.g. the control unit of a switching apparatus, a protection relay or another computerised device.

According to the invention, the electronic arrangement 20 comprises a first amplification stage 21.

The first amplification stage 21 is electrically connected between the input terminal T1 and an intermediate terminal T2 of the electronic arrangement 20.

In operation, the first amplification stage 21 receives and processes the first detection signals DS1 (preferably including analog voltage signals) provided by the voltage sensing unit 10 and it provides second detection signals DS2 (preferably including analog voltage signals) indicative of voltage levels of the line conductor 101.

Preferably, the second detection signals DS2 are provided at the above-mentioned intermediate terminal T2 of the electronic arrangement 20.

In general, the first amplification stage 21 provides the second detection signals DS2 by amplifying the first detection signals DS1 with a first amplification gain G1.

An essential feature of the first amplification stage 21, however, consists in that it comprises a first tuning circuit TC1 adapted to automatically tune the first amplification gain G1 of the amplification stage in response to environmental temperature variations.

In this way, the first amplification stage can provide a first amplification gain variable as a function of temperature.

The first amplification stage 21 can therefore amplify the first detection signals DS1 and compensate, at least partially, possible temperature drift errors that affect the first detection signals DS1 and that are due to temperature variations of the voltage-sensing unit 10.

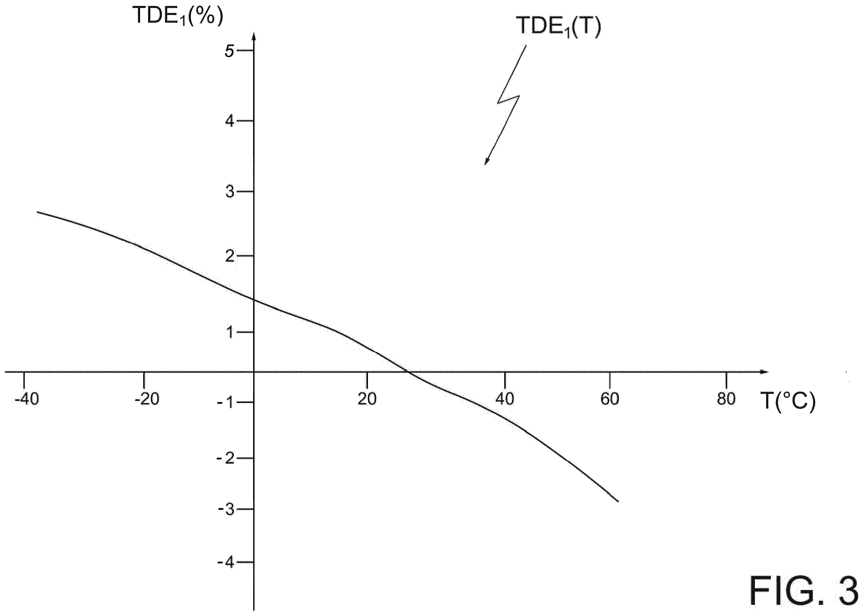

Referring to figures 3-5, it is shown how the first amplification stage 21 can compensate possible temperature drift errors affecting the first detection signals DS1.

Figure 3 schematically shows an example of temperature drift error $TDE_1(T)$, which normally affects the voltage measurements (i.e. the first detection signals DS1) provided by the voltage sensing unit 10. The temperature drift error $TDE_1(T)$ is represented as a function of temperature over a given temperature range (in this case spanning from -40°C to +60°C).

As it is possible to notice, the temperature drift error $TDE_1(T)$ is highly variable with temperature and it takes relatively high values (more than 3%) at the ends of the considered temperature range.

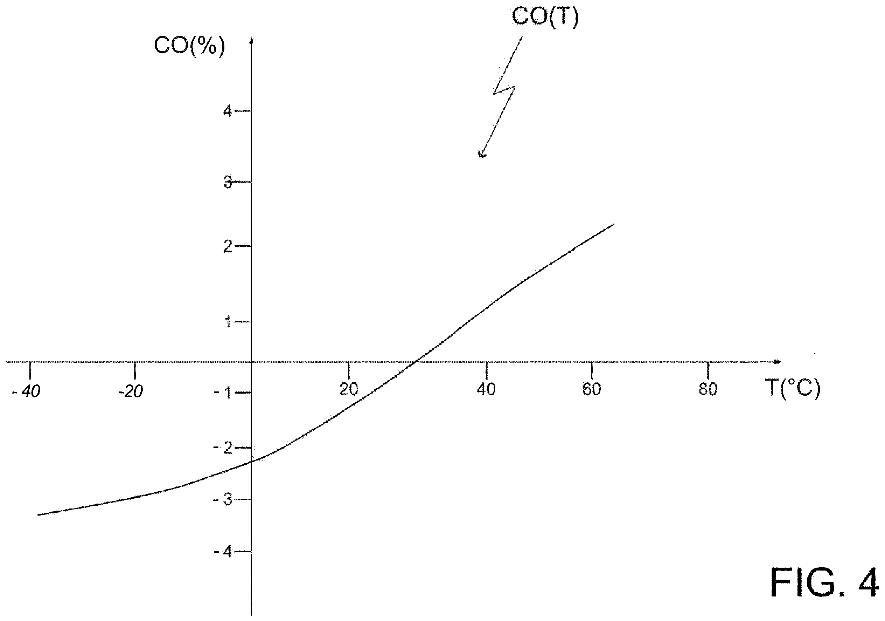

In figure 4, it is shown an example of correction offset CO(T) that can be introduced by the amplification stage 21 thanks to the tuning action provided by the first tuning circuit TC1. Also the correction offset CO(T) is represented as a function of temperature over a the above-mentioned temperature range.

As it is possible to notice, the compensation offset CO(T) has a behaviour highly variable with temperature but substantially complementary with respect to the behaviour of the temperature drift error shown above.

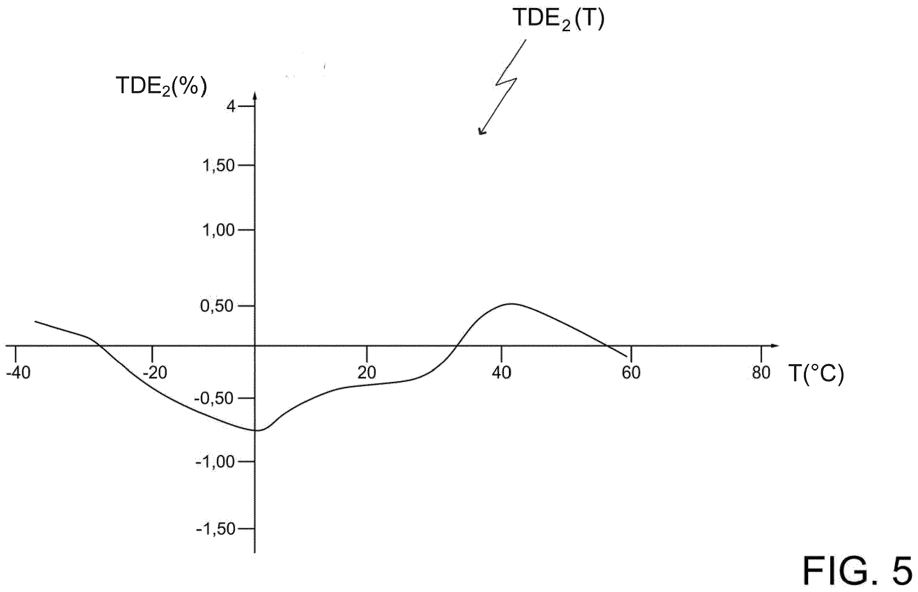

In figure 5, it is schematically shown an example of temperature drift error $TDE_2(T)$ typically affecting the second detection signals DS2 provided in output by the first amplification stage 21 upon the compensation action carried out by means of the tuning circuit TC1.

Also the temperature drift error $TDE_2(T)$ is represented as a function of temperature over a the above-mentioned temperature range.

As it is possible to notice, the temperature drift error $TDE_2(T)$ varies smoothly with temperature and it does not exceed a relatively narrow variation range (e.g. +/- 0.6%) over the considered temperature range.

Thanks to the tuning circuit TC1, while amplifying the first detection signals DS1, the amplification stage 21 can automatically correct possible temperature drift errors affecting the first detection signals DS1 and provide in output compensated second detection signals S2, which are affected by relatively small temperature drift errors and that are therefore particularly suitable for being further processed.

In fact, thanks to the tuning action exerted by the first tuning circuit TC1, the temperature drift error $TDE_2$ affecting the second detection signals DS2, for a given temperature T included in the considered temperature range, is provided by the following relation:

$$TDE_2\ (T) = TDE_1\ (T) + CO(T)$$

where $TDE_1(T)$ is the temperature drift error affecting the first detection signals DS1 for said given temperature T and CO(T) is the correction offset introduced by the first amplification stage 21 for said given temperature T.

The first tuning circuit TC1 comprises one or more thermistors Rte of the NTC type. Thanks to adoption of NTC thermistors in the tuning circuit TC1, the amplification stage 21 can easily provide a compensation offset CO(T) having a behaviour variable with temperature and substantially complementary with respect to the typical behaviour of the temperature drift error $TDE_1(T)$ affecting the voltage measurements (i.e. the first detection signals DS1) provided by the voltage sensing unit 2.

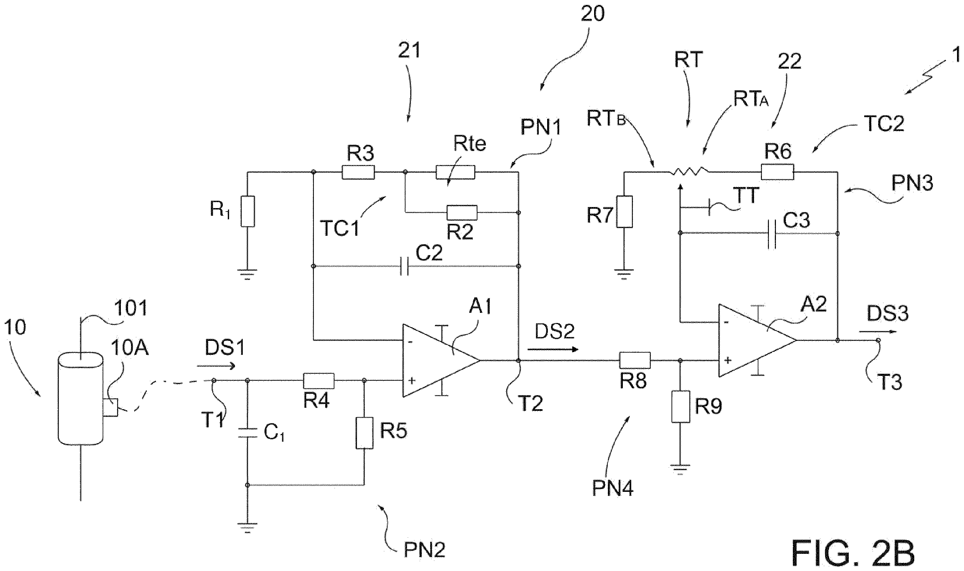

According to the preferred embodiment shown in figure 2B, the first amplification stage 21 comprises a first operational amplifier A1.

The first amplification stage 21 comprises a first polarization network PN1 adapted to set the first amplification gain G1 provided by the first amplification stage 21.

Preferably, the first operational amplifier A1 is arranged in a non-inverting configuration. The first polarization network PN1 is thus electrically connected with the inverting input terminal of the operational amplifier A1.

According to configurations of known type, the first polarization network PN1 includes:

- a first setting section, which includes the resistor R1 in the illustrated embodiment and which is electrically connected between the inverting input terminal of the operational amplifier A1 and the ground;
- a second setting section, which includes the resistor R3 electrically connected in series with the parallel of the resistor R2 and the NTC thermistor Rte in the illustrated embodiment and which is electrically connected between the inverting input terminal and the output terminal of the operational amplifier A1.

Preferably, the first polarization network PN1 includes also a low-pass filter, which includes the capacitor C2 in the illustrated embodiment and which is electrically connected between the inverting input terminal and the output terminal of the operational amplifier A1. Conveniently, the second setting section of the first polarization network PN1 constitutes the first tuning circuit TC1 of the first amplification stage 21.

The second setting section of the first polarization network PN1, in fact, includes the NTC thermistor Rte, which has impedance that can vary with the environmental temperature.

According to the embodiment shown in figure 2B, the first amplification stage 21 provides a first amplification gain G1 that is given by the following relation:

$$G1\ =\ 1 + \frac{R3 + \dfrac{Rte(T) * R2}{Rte(T) + R2}}{R1}$$

where R1, R2, R3 are the resistive impedances of the above-mentioned resistors R1, R2, R3 and Rte(T) is the temperature variable resistive impedance of the above-mentioned NTC thermistors Rte.

It is apparent how the first amplification stage 21 can provide a first amplification gain G1 that can vary with the environmental temperature.

Preferably, the first amplification stage 21 further comprises a second polarization network PN2 adapted to set and filter the voltage signals (proportional to the first detection signals DS1) received in input by the first operational amplifier A1.

As the first operational amplifier is arranged in a non-inverting configuration, the second polarization network PN2 is electrically connected with the non-inverting input terminal of the operational amplifier A1.

Preferably, according to configurations of known type, the second polarization network PN2 includes a RC circuit electrically connected between the input terminal T1 of the electronic arrangement 29, the non-inverting input terminal of the operational amplifier A1 and the ground.

According to an aspect of the invention, the amplification arrangement 20 comprises at least the first amplification stage 21 arranged in proximity of the voltage-sensing unit 10.

In this way, the first tuning circuit TC1 can tune the first amplification gain G1 provided by the first amplification stage 20 in response to environmental temperature variations in proximity of the voltage sensing unit 2.

Said environmental temperature variations can be assumed as substantially following possible temperature variations of the voltage-sensing unit 10. The first amplification stage 21 can thus compensate more effectively temperature drift errors affecting the first detection signals DS 1 due to temperature variations of the voltage-sensing unit 2.

According to the invention, the amplification arrangement 20 comprises a second amplification stage 22 operatively coupled in cascade with the first amplification stage 21.

The second amplification stage 22 is electrically connected between the intermediate terminal T2 and the output terminal T3 of the electronic arrangement 20.

In operation, the second amplification stage 22 receives and processes the second detection signals DS2 provided by the first amplification stage 21 and it provides third detection signals DS3 (preferably including analog voltage signals) indicative of voltage levels of the line conductor 101.

Preferably, the third detection signals DS3 are provided at the above-mentioned output terminal T3 of the electronic arrangement 20.

In general, the second amplification stage 22 provides the third detection signals DS3 by amplifying the second detection signals DS2 with a second amplification gain G2.

The second amplification stage 22 comprises a second tuning circuit TC2 operatively coupled with a tuning terminal TT of the electronic arrangement 20.

The tuning terminal TT may include a suitable port of the electronic arrangement that is equipped with tuning means (e.g. a screw) that can be manually operated by means of a suitable tuning tool.

The second tuning circuit TC2 is adapted to tune the second amplification gain G2 provided by the second amplification stage in response to manual interventions of an operator on the tuning terminal TT.

In this way, the second amplification stage 22 provides a second amplification gain G2 that can be manually tuned by an operator intervening on the tuning terminal TT, e.g. while installing the detection device 1 on the field.

The second amplification stage 22 can therefore provide an amplification gain G2 that can be varied depending on specific operating conditions required for the detection device 1. Preferably, the second tuning circuit TC2 comprises one or more trimming resistors $R_T$ operatively coupled with the tuning terminal TT.

According to the preferred embodiment shown in figure 2B, the second amplification stage 22 comprises a second operational amplifier A2.

The second amplification stage 22 comprises a third polarization network PN2 adapted to set the second amplification gain G2 provided by the second amplification stage 22.

Preferably, the second operational amplifier A2 is arranged in a non-inverting configuration. The third polarization network PN3 is thus electrically connected with the inverting input terminal of the operational amplifier A2.

According to configurations of known type, the third polarization network PN3 includes:

- a third setting section, which includes the resistor R7 and the portion $RT_B$ of the trimming resistor RT electrically connected in series in the illustrated embodiment and which is electrically connected between the inverting input terminal of the operational amplifier A2 and the ground;
- a fourth setting section, which includes the portion $RT_A$ of trimming resistor RT and the resistor R6 electrically connected in series in the illustrated embodiment and which is electrically connected between the inverting input terminal and the output terminal of the operational amplifier A2.

Obviously, the resistive impedances of the portions $RT_A$, $RT_B$ of the trimming resistor RT may be varied depending on the operating condition (e.g. the position) of the tuning terminal TT operatively coupled with the trimming resistor RT.

Preferably, the third polarization network PN3 includes also a low-pass filter, which includes the capacitor C3 in the illustrated embodiment and which is electrically connected between the inverting input terminal and the output terminal of the operational amplifier A1. Conveniently, the second resistive section of the third polarization network PN3 constitutes the second tuning circuit TC2 of the second amplification stage 22.

The fourth setting section of the third polarization network PN3, in fact, includes the trimming resistor RT, which has impedance that can vary depending on the operating condition of the tuning terminal TT.

According to the preferred embodiment shown in figure 2B, the second amplification stage 22 provides a second amplification gain G2 that is given by the following relation:

$$G2 = 1 + \frac{RT_A + R6}{R7 + RT_B}$$

where R6, R7 are the resistive impedances of the above-mentioned resistors R6, R7 and $RT_A$, $RT_B$ are the resistive impedances of the above-mentioned portions $RT_A$, $RT_B$ of the above-mentioned trimming resistor RT, which can be varied depending on the operating condition (e.g. the operating position) taken by the tuning terminal TT.

It is apparent how the second amplification stage 22 can provide a second amplification gain G2 that can vary with the position of the tuning terminal TT, which, in turn, can be set by a manual intervention of an operator.

Preferably, the second amplification stage 22 further comprises a fourth polarization network PN4 adapted to set the voltage signals (proportional to the second detection signals DS2) received in input by the second operational amplifier A2.

As the operational amplifier A2 is arranged in a non-inverting configuration, the fourth polarization network PN4 is electrically connected with the non-inverting input terminal of the operational amplifier A2.

Preferably, according to configurations of known type, the fourth polarization network PN4 includes a resistive circuit electrically connected between the intermediate terminal T2 providing the second detection signals DS2, the non-inverting input terminal of the operational amplifier A2 and the ground.

In figure 1, a MV installation 200 including a plurality of detection devices 1 according to the invention is shown.

In the embodiment shown in figure 1, the MV installation 200 is a MV switching device, such as a circuit breaker, a contactor, a disconnector, and the like.

The MV switching device 200 is electrically connected with an electric line 100 of the three-phase type.

The electric line 100 comprises a source portion 100A and a load portion 100B, each including three line conductors 101.

The MV switching device 200 comprises three electric poles 200A, each including electric contacts (not shown) that can be mutually coupled or decoupled.

Each electric pole 200A comprises a pair of voltage detection devices 1 in such a way to measure the operating voltages of corresponding line conductors 101 of the source and portions 100A, 100B of the electric line 100.

Each voltage detection device 1 is arranged with the corresponding sensing unit 10 fixed on the insulating case 200B of the switching device 200 in such way to protrude from this latter and to be electrically connected with a corresponding line conductor 101.

Each voltage detection device 1 has the corresponding electronic arrangement 20 that is accommodated in a suitable support box 200C of the switching device 200.

The support box 200C is fixed on the insulating case 200B in proximity of the sensing units 10 in such a way to be substantially in thermal contact with these latter. In this way, each electronic arrangement 20 (in particular each amplification stage 21 thereof) can operate at an environmental temperature that substantially follows the operating temperature of the corresponding voltage sensing unit 10.

Conveniently, each electronic arrangement 20 accommodated in the support box 200C may communicate in a wired or wireless manner with a local or remote electronic device (not shown).

The detection device 1, according to the invention, may be subject to a number of variants falling within the scope of the present invention and evident to the skilled person.

As an example, the first and second amplification stages 21, 22 may be realized according to circuital configurations different from those of the preferred embodiment shown in figure 2B, even if still including the corresponding first and second tuning circuits TC1, TC2.

Furthermore, but not falling under the claimed scope of a single device, the electronic arrangement 20 may include the first amplification stage 21 arranged in proximity of the voltage sensing unit 10 and the second amplification stage 22 arranged remotely with respect to said voltage sensing unit, even integrated in a remote electronic device.

The voltage detection device 1, according to the invention, provides remarkable advantages with respect to known detection devices for MV installations of the state of the art.

The detection device 1 is equipped with a voltage-sensing unit 10 including a capacitive voltage divider sensing arrangement.

The detection device 1 can thus provide the above-described technical advantages characterising the voltage detection devices of capacitive type.

The voltage detection device 1 comprises an electronic arrangement 20 capable of amplifying the first detection signals provided by the voltage-sensing unit and, at the same time, automatically correcting temperature drift errors typically affecting said voltage measurements.

The voltage detection device 1 can thus provide outstanding performances in terms of voltage measurement accuracy.

Laboratory tests have shown how the detection device 1 can provide class 1 accuracy performances, which are therefore remarkably higher that the class 3-6 accuracy performances normally provided by currently available voltage detection devices of the state of the art.

Thanks to the gain tuning capabilities provided by the first tuning circuit TC1 of the first amplification stage 21, the detection device 1 can ensure the above-described outstanding measurement accuracy levels over an extended range of temperatures, normally spanning from -40 °C to +60 °C.

Thanks to the gain tuning capabilities provided by the second tuning circuit TC2 of the second amplification stage 22, the detection device 1 is characterised a high flexibility of use as its operating amplification functionalities can be easily set on the field depending on the needs.

The voltage detection device 1 has a relatively simple and compact structure, which makes it relatively easy to manufacture at industrial level and install on the field.

**Claims**

1. A detection device (1) for medium voltage electric installations comprising:

   - a voltage sensing unit (10) including a capacitive voltage divider sensing arrangement, said voltage sensing unit being operatively coupleable with a line conductor (101) of an electric line (100) and being adapted to provide first detection signals (DS1) indicative of voltage levels of said line conductor;
   - an electronic arrangement (20) operatively coupled with said voltage sensing unit (10);
   wherein said electronic arrangement (20) comprises:

      - a first amplification stage (21) adapted to receive and process said first detection signals (DS1) and provide second detection signals (DS2) indicative of voltage levels of said line conductor (101), wherein said first amplification stage comprises a first tuning circuit (TC1) comprising one or more thermistors (Rte) of the NTC type, said first tuning circuit being adapted to tune a first amplification gain (G1) of said first amplification stage in response to environmental temperature variations, so that said first amplification stage (21) can amplify said first detection signals (DS1) and, at the same time, compensate, at least partially, temperature drift errors affecting said first detection signals due to temperature variations of said voltage sensing unit (10);

said electronic arrangement (20) further comprising:

- a second amplification stage (22) operatively coupled in cascade with said first amplification stage (21) and adapted to receive and process said second detection signals (DS2) and provide third detection signals (DS3) indicative of voltage levels of said line conductor,

wherein said second amplification stage (22) comprises a second tuning circuit (TC2) operatively coupled with a tuning terminal (TT) of said electronic arrangement (20), said second tuning circuit being adapted to tune a second amplification gain (G2) of said second amplification stage in response to manual interventions of an operator on said tuning terminal (TT),

wherein said second tuning circuit (TC2) comprises one or more trimming resistors ($R_T$) operatively coupled with said tuning terminal (TT).

2. A detection device, according to claim 1, **characterised in that** said first amplification stage (21) comprises a first operational amplifier (A1) and a first network (PN1) operatively coupled with said first operational amplifier to set said first amplification gain (G1), said first network including said first tuning circuit (TC1).

3. A detection device, according to one or more of the previous claims, **characterised in that** said electronic arrangement (20) comprises at least said first amplification stage (21) arranged in proximity of said voltage sensing unit (10), so that environmental temperature variations follow temperature variations of said voltage sensing unit.

4. A detection device, according to one of the previous claims, **characterised in that** said second amplification stage (22) comprises a second operational amplifier (A2) and a third network (PN3) operatively coupled with said second operational amplifier to set said second amplification gain (G2), said third network including said second tuning circuit (TC2).

5. A medium voltage, MV, installation (200) **characterised in that** it comprises a detection device (1), according to one or more of the previous claims.

## Patentansprüche

1. Detektionsvorrichtung (1) für elektrische Mittelspannungsanlagen, die Folgendes umfasst:

- eine Spannungserfassungseinheit (10), die eine kapazitive Spannungsteiler-Erfassungsanordnung aufweist, wobei die Spannungserfassungseinheit betriebsfähig mit einem Leitungsleiter (101) einer elektrischen Leitung (100) koppelbar ist und ausgelegt ist, erste Detektionssignale (DS1) zu liefern, die die Spannungspegel des Leitungsleiters anzeigen;
- eine elektronische Anordnung (20), die betriebsfähig mit der Spannungserfassungseinheit (10) gekoppelt ist;
wobei die elektronische Anordnung (20) Folgendes umfasst:

- eine erste Verstärkungsstufe (21), die ausgelegt ist, die ersten Detektionssignale (DS1) zu empfangen und zu verarbeiten und zweite Detektionssignale (DS2) bereitzustellen, die die Spannungspegel des Leitungsleiters (101) anzeigen, wobei die erste Verstärkungsstufe eine erste Abstimmschaltung (TC1) umfasst, die einen oder mehrere Thermistoren (Rte) vom NTC-Typ umfasst, wobei die erste Abstimmschaltung ausgelegt ist, um einen ersten Verstärkungsfaktor (G1) der ersten Verstärkungsstufe in Reaktion auf Umgebungstemperaturschwankungen abzustimmen, so dass die erste Verstärkungsstufe (21) die ersten Detektionssignale (DS1) verstärken und gleichzeitig zumindest teilweise Temperaturdriftfehler kompensieren kann, die die ersten Detektionssignale aufgrund von Temperaturschwankungen der Spannungserfassungseinheit (10) beeinflussen;
wobei die elektronische Anordnung (20) ferner Folgendes umfasst:
- eine zweite Verstärkungsstufe (22), die betriebsfähig in Kaskade mit der ersten Verstärkungsstufe (21) gekoppelt ist und ausgelegt ist, die zweiten Detektionssignale (DS2) zu empfangen und zu verarbeiten und dritte Detektionssignale (DS3) bereitzustellen, die Spannungspegel des Leitungsleiters anzeigen,

wobei die zweite Verstärkungsstufe (22) eine zweite Abstimmschaltung (TC2) umfasst, die betriebsfähig mit einem Abstimmanschluss (TT) der elektronischen Anordnung (20) gekoppelt ist, wobei die zweite Abstimmschaltung ausgelegt ist, um einen zweiten Verstärkungsfaktor (G2) der zweiten Verstärkungsstufe in Reaktion auf manuelle Eingriffe eines Bedieners an dem Abstimmanschluss (TT) abzustimmen, wobei die zweite Abstimmschaltung (TC2) einen oder mehrere Trimmwiderstände ($R_T$) umfasst, die betriebsfähig mit dem Abstimmanschluss (TT) gekoppelt sind.

2. Detektionsvorrichtung nach Anspruch 1, **dadurch gekennzeichnet, dass** die erste Verstärkungsstufe (21) einen ersten Operationsverstärker (A1) und ein erstes Netzwerk (PN1) umfasst, das betriebsfähig mit dem ersten Operationsverstärker gekoppelt ist, um den ersten Verstärkungsfaktor (G1) einzustellen, wobei das erste Netzwerk die erste Abstimmschaltung (TC1) enthält.

3. Detektionsvorrichtung nach einem oder mehreren der vorhergehenden Ansprüche, **dadurch gekennzeichnet, dass** die elektronische Anordnung (20) mindestens die erste Verstärkungsstufe (21) umfasst, die in der Nähe der Spannungserfassungseinheit (10) angeordnet ist, so dass Umgebungstemperaturschwankungen Temperaturschwankungen der Spannungserfassungseinheit folgen.

4. Detektionsvorrichtung nach einem der vorhergehenden Ansprüche, **dadurch gekennzeichnet, dass** die zweite Verstärkungsstufe (22) einen zweiten Operationsverstärker (A2) und ein drittes Netzwerk (PN3) umfasst, das betriebsfähig mit dem zweiten Operationsverstärker gekoppelt ist, um den zweiten Verstärkungsfaktor (G2) einzustellen, wobei das dritte Netzwerk die zweite Abstimmschaltung (TC2) enthält.

5. Mittelspannungs-(MV)-Anlage (200), **dadurch gekennzeichnet, dass** sie eine Detektionsvorrichtung (1) nach einem oder mehreren der vorhergehenden Ansprüche umfasst.

**Revendications**

1. Dispositif de détection (1) pour installations électriques moyenne tension comprenant :

- une unité de détection de tension (10) comportant un agencement de détection à diviseur de tension capacitif, ladite unité de détection de tension pouvant être couplée de manière fonctionnelle avec un conducteur de ligne (101) d'une ligne électrique (100) et étant conçue pour fournir des premiers signaux de détection (DS1) indiquant des niveaux de tension dudit conducteur de ligne ;
- un agencement électronique (20) couplé de manière fonctionnelle à ladite unité de détection de tension (10) ;

dans lequel ledit agencement électronique (20) comprend :

- un premier étage d'amplification (21) conçu pour recevoir et traiter lesdits premiers signaux de détection (DS1) et fournir des deuxièmes signaux de détection (DS2) indiquant des niveaux de tension dudit conducteur de ligne (101), dans lequel ledit premier étage d'amplification comprend un premier circuit d'accord (TC1) comprenant une ou plusieurs thermistances (Rte) de type CTN, ledit premier circuit d'accord étant conçu pour accorder un premier gain d'amplification (G1) dudit premier étage d'amplification en réponse à des variations de température ambiante, de sorte que ledit premier étage d'amplification (21) peut amplifier lesdits premiers signaux de détection (DS1) et, en même temps, compenser, au moins partiellement, des erreurs de dérive de température affectant lesdits premiers signaux de détection à cause de variations de température de ladite unité de détection de tension (10) ; ledit agencement électronique (20) comprenant en outre :
- un deuxième étage d'amplification (22) couplé de manière fonctionnelle en cascade audit premier étage d'amplification (21) et conçu pour recevoir et traiter lesdits deuxièmes signaux de détection (DS2) et fournir des troisièmes signaux de détection (DS3) indiquant des niveaux de tension dudit conducteur de ligne,

dans lequel ledit deuxième étage d'amplification (22) comprend un deuxième circuit d'accord (TC2) couplé de manière fonctionnelle à une borne d'accord (TT) dudit agencement électronique (20), ledit deuxième circuit d'accord étant conçu pour accorder un deuxième gain d'amplification (G2) dudit deuxième étage d'amplification en réponse à des interventions manuelles d'un opérateur sur ladite borne d'accord (TT), dans lequel ledit deuxième circuit d'accord (TC2) comprend une ou plusieurs résistances d'équilibrage ($R_T$) couplées de manière fonctionnelle à ladite borne d'accord (TT).

2.   Dispositif de détection selon la revendication 1, **caractérisé en ce que** ledit premier étage d'amplification (21) comprend un premier amplificateur opérationnel (A1) et un premier réseau (PN1) couplé de manière fonctionnelle audit premier amplificateur opérationnel pour définir ledit premier gain d'amplification (G1), ledit premier réseau comportant ledit premier circuit d'accord (TC1).

3.   Dispositif de détection selon une ou plusieurs des revendications précédentes, **caractérisé en ce que** ledit agencement électronique (20) comprend au moins ledit premier étage d'amplification (21) agencé à proximité de ladite unité de détection de tension (10), de sorte que des variations de température ambiante suivent des variations de température de ladite unité de détection de tension.

4.   Dispositif de détection selon l'une des revendications précédentes, **caractérisé en ce que** ledit deuxième étage d'amplification (22) comprend un deuxième amplificateur opérationnel (A2) et un troisième réseau (PN3) couplé de manière fonctionnelle audit deuxième amplificateur opérationnel pour définir ledit deuxième gain d'amplification (G2), ledit troisième réseau comportant ledit deuxième circuit d'accord (TC2).

5.   Installation moyenne tension, MV (200), **caractérisée en ce qu'**elle comprend un dispositif de détection (1) selon une ou plusieurs des revendications précédentes.

FIG. 1

EP 3 719 507 B1

FIG. 2A

FIG. 2B

$TDE_1(T)$

$TDE_1(\%)$

$T(°C)$

**FIG. 3**

FIG. 4

EP 3 719 507 B1

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 102608378 A
- DE 3640242 A1
- CN 107340424 A